# EUROPÄISCHE PATENTSCHRIFT

(11) **EP 3 391 455 B1**
(45) Veröffentlichungstag und Bekanntmachung des Hinweises auf die Patenterteilung: **11.09.2019**
(21) Anmeldenummer: 17702575.6
(22) Anmeldetag: 26.01.2017
(51) Int. Cl.: H01M 10/42, H01M 10/48, B60L 3/12, H02J 7/00, G01R 31/392, B60L 58/16, B60L 58/13, B60L 58/24

(54) **LEBENSDAUERSTEUERUNG FÜR ENERGIESPEICHER**
LIFE CYCLE MANAGEMENT FOR AN ENERGY STORE
COMMANDE DE DUREE DE VIE POUR ACCUMULATEUR D'ENERGIE

(30) Priorität: 08.02.2016 EP 16154678
(43) Veröffentlichungstag der Anmeldung: 24.10.2018
(73) Patentinhaber: Siemens Aktiengesellschaft, 80333 München (DE)
(72) Erfinder: RUPPERT, Swen, 91096 Möhrendorf (DE); HOLL, Eugen, Shanghai 2000041 (CN)
(86) Internationale Anmeldenummer: PCT/EP2017/051648
(87) Internationale Veröffentlichungsnummer: WO 2017/137263

(56) Entgegenhaltungen:
- EP-A2- 2 141 763
- WO-A1-2015/055454
- DE-A1-102007 026 136
- DE-A1-102012 000 847
- DE-A1-102014 200 645
- DE-A1-102014 212 451
- DE-C1- 10 201 136

## Beschreibung

Die Erfindung betrifft ein Verfahren zur Steuerung der Lebensdauer eines Energiespeichermoduls, wobei zu unterschiedlichen Zeitpunkten ein Alterungszustand des Energiespeichermoduls bekannt ist. Die Erfindung betrifft weiter ein Verfahren zur Steuerung der Lebensdauer einer Vielzahl von Energiespeichermodulen. Ferner betrifft die Erfindung eine Steuerung für ein Energiespeichermodul sowie ein Energiespeichermodul und ein Energiespeichersystem mit einer solchen Steuerung. Weiter betrifft die Erfindung ein Fahrzeug mit einem solchen Energiespeichermodul.

Ein Energiespeicher kann aus einem oder mehreren Energiespeichermodulen aufgebaut sein. Dabei umfasst das Energiespeichermodul oftmals Sensoren zur Bestimmung der Temperatur des Energiespeichermoduls. Darüber hinaus ist dem Energiespeichermodul oftmals eine Regel- oder Steuereinheit zugeordnet, mit der das Verhalten und der Betrieb des Energiespeichermoduls beeinflusst werden kann.

Als Energiespeicher oder Energiespeichermodul kommen heute, insbesondere in einem Antriebssystem für Fahrzeuge, vorzugsweise Doppelschichtkondensatoren (sog. SuperCaps oder UltraCaps) oder Batterien zum Einsatz.

Es ist bekannt, dass Betriebsbedingungen und externe Einflüsse eines Energiespeichers oder eines Energiespeichermoduls die Grenzen des Energiespeichers und die Kühlung bestimmen. Dabei werden beispielsweise bei Übertemperatur die Stromgrenzen reduziert, in Abhängigkeit des Ladezustands (SoC, State of Charge) die Nachladung eingeschränkt oder in einem Hybridsystem bei niedrigem SoC eine weitere Leistungs- oder Energiequelle dazu geschaltet. Darüber hinaus kann die Kühlung verstärkt werden.

Aus der DE 10 2013 213 253 A1 ist bekannt, dass sich durch die Änderung der Betriebsparameter die Wirkungsgrade von Energiespeichersystemen beeinflussen lassen.

Temperatur und Spannung haben teilweise einen großen Einfluss auf die Lebensdauer von elektrischen Energiespeichern (Doppelschichtkondensatoren, Ultracaps und Batterien). Der Strom hat wiederum über die Erwärmung einen Einfluss auf die Temperatur.

Will man aufgrund von Leasingverträgen oder Garantieleistungen eine definierte Lebensdauer des Energiespeichersystems garantieren, wird heute eine konservative Auslegung durchgeführt, die Sicherheiten bezüglich der Lebensdauer beinhaltet, und mit Toleranz versehen. Dieser Toleranzpuffer ist mit zusätzlichem Aufwand und damit Kosten oder Verlusten verbunden, wie beispielsweise einer Überdimensionierung, einer Einschränkung der Betriebsparameter (z.B. der Maximalspannung) oder einer hohen installierten Kühlleistung.

Der Alterungszustand, auch als Lebensalter eines Energiespeichersystems bezeichnet, wird oft aus der Kapazität oder anderen Parametern, wie beispielsweise Innenwiderstand abgeleitet. Dazu sind Algorithmen bekannt, um den Alterungszustand des Energiespeichermoduls zu bestimmen. Der Alterungszustand wird dabei oftmals in SoH (State of Health) ausgedrückt. Dabei gilt 100% als neuwertig. Üblicherweise wird bei ca. 80% der kritische Alterungszustand erreicht, bei der man aus Sicherheitsgründen oder zur Sicherstellung eines einwandfreien Betriebs den Energiespeicher außer Betrieb nehmen sollte. Andere Definitionen definieren den kritischen Alterungszustand bei 0%. Unabhängig von der Definition des Alterungszustands (SoH) ist beim kritischen Alterungszustand noch immer die Fähigkeit vorhanden, Energie zu speichern oder abzugeben.

Oft wird die garantierte Lebensdauer eines Energiespeichersystems für die Anlage (z.B. Fahrzeug) ausgelegt, in der der Energiespeicher Energie puffern soll. Dabei ist oftmals die Lebensdauer der Anlage gleich oder doppelt so hoch wie die kalkulierte Lebensdauer des Energiespeichersystems.

Aus der EP 2 481 123 B1 ist ein Verfahren zur Steuerung bzw. Regelung mindestens eines den Alterungszustand eines elektrischen Energiespeichers beeinflussenden Betriebsparameters des elektrischen Energiespeichers mit den Schritten Ermitteln des tatsächlichen Alterungszustands des elektrischen Energiespeichers, Vergleichen des tatsächlichen Alterungszustands mit einem für das momentane Alter des Energiespeichers vorgegebenen Soll-Alterungszustand und Einschränken eines für den mindestens einen Betriebsparameter zugelassenen Betriebsparameterbereichs, wenn der tatsächliche Alterungszustand schlechter als der Soll-Alterungszustand ist, bekannt.

Die DE 10 2012 000 847 A1 offenbart ein weiteres Verfahren zur Steuerung der Lebensdauer eines Energiespeichermoduls.

Der Erfindung liegt die Aufgabe zugrunde, die Steuerung oder Regelung der Lebensdauer eines Energiespeichermoduls zu verbessern.

Die Aufgabe wird durch ein Verfahren zur Steuerung der Lebensdauer eines Energiespeichermoduls gelöst, wobei zu unterschiedlichen Zeitpunkten ein Alterungszustand des Energiespeichermoduls bekannt ist, wobei ein erster Alterungszustand bekannt ist, in dem sich das Energiespeichermodul zu einem ersten Zeitpunkt befindet, und ein zweiter Alterungszustand bekannt ist, in dem sich das Energiespeichermodul zu einem zweiten Zeitpunkt befindet, wobei aus dem ersten und dem zweiten Alterungszustand und dem ersten und dem zweiten Zeitpunkt eine Alterungsgeschwindigkeit ermittelt wird, wobei aus der Alterungsgeschwindigkeit und einem der Alterungszustände ein Zeitpunkt eines ermittelten Lebensdauerendes berechnet wird, wobei in Abhängigkeit von dem Zeitpunkt des ermittelten Lebensdauerendes eine Maßnahme zur Veränderung der Lebensdauer des Energiespeichermoduls angewendet wird, wobei das Energiespeichermodul Doppelschichtkondensatoren umfasst, wobei die Kühlleistung des Energiespeichermoduls gesteigert wird, wenn eine im Energiespeichermodul gemessene Temperatur größer ist als ein gemittelter oder geglätteter Wert der im Energiespeichermodul gemessenen Temperatur und/oder wenn eine gemessene Umgebungstemperatur größer ist als ein gemittelter oder geglätteter Wert der gemessenen Umgebungstemperatur. Die Aufgabe wird weiter durch ein Verfahren zur Steuerung der Lebensdauer einer Vielzahl von Energiespeichermodulen gelöst, wobei mindestens ein erstes Energiespeichermodul der Vielzahl von Energiespeichermodulen mit einem ersten Zeitpunkt des ermittelten Lebensdauerendes mittels eines zuvor genannten Verfahrens derart geregelt werden, dass der erste Zeitpunkt des ermittelten Lebensdauerendes sich einem vorgebbaren Zeitpunkt annähert. Ferner wird die Aufgabe durch eine Steuerung für ein Energiespeichermodul mit Mitteln zur Durchführung eines solchen Verfahrens, sowie durch ein Programm zur Durchführung eines solchen Verfahrens bei Ablauf in einer solchen Steuerung und durch ein Computerprogrammprodukt gelöst. Weiter wird die Aufgabe durch ein Energiespeichermodul mit einer solchen Steuerung, einem Energiespeichersystem mit einer Vielzahl von Energiespeichermodulen sowie durch ein Fahrzeug mit einem solchen Energiespeichermodul gelöst.

Vorteilhafte Ausgestaltungen der Erfindung sind in den abhängigen Ansprüchen angegeben.

Der Erfindung liegt die Erkenntnis zugrunde, dass aus den Alterungszuständen (SoH) zu unterschiedlichen Zeitpunkten ein voraussichtliches Lebensdauerende des Energiespeichermoduls berechnet werden kann. Für die Berechnung muss der Alterungszustand (SoH) an mindestens zwei unterschiedlichen Zeitpunkten bekannt sein. Bildet man die Differenz der beiden Alterungszustände (des ersten und des zweiten Alterungszustands) und teilt diese durch die Differenz der beiden Zeitpunkte, so erhält man aus diesen beiden Alterungszuständen eine Alterungsgeschwindigkeit. Aus einem Alterungszustand und dem dazugehörigen Zeitpunkt kann mit Hilfe der berechneten Alterungsgeschwindigkeit das Ende der Lebensdauer bestimmt werden. Dabei kann sowohl einer der Alterungszustände, d.h. der erste oder der zweite Alterungszustand, herangezogen werden, der bereits für die Berechnung der Alterungsgeschwindigkeit verwendet wurde, oder jeder beliebige bekannte Alterungszustand mit dem dazugehörigen Zeitpunkt. Mit Hilfe des Alterungszustands zu einem bestimmten Zeitpunkt kann berechnet werden, wann ein definierter Alterungszustand, der das Ende des Energiespeichermoduls definiert, erreicht wird. Dies geschieht auf einfache Weise dadurch, dass man bei der Berechnung davon ausgeht, dass sich die Alterung mit der errechneten Alterungsgeschwindigkeit weiter fortsetzt.

Anhand dieses Zeitpunkts für das Erreichen des Lebensdauerendes kann entschieden werden, ob Maßnahmen zur Veränderung der Lebensdauer durch eine Regelung oder Steuerung vorgenommen werden.

Dem zuvor beschriebenen Verfahren handelt es sich um eine Linearisierung durch zwei Punkte. Anschaulich wird bei der Bestimmung der Alterungsgeschwindigkeit eine Gerade durch diese zwei Punkte gelegt und ein Schnittpunkt berechnet, wann diese Gerade einen definierten Alterungszustand erreicht, d.h. einen Wert parallel zur Zeitachse schneidet, bei dem das Energiespeichermodul ausgetauscht werden muss. Dieser Schnittpunkt stellt den berechneten Zeitpunkt des Lebensdauerendes dar.

Alternative sind aus der Mathematik eine Vielzahl von Verfahren, insbesondere statistische Verfahren, bekannt, aus einer Menge von Punkten oder Messpunkten in einem zweidimensionalen Raum eine Gerade oder Ausgleichsgerade zu ermitteln bzw. zu interpolieren. All diese Verfahren eignen sich zur Bestimmung der Alterungsgeschwindigkeit eines Energiespeichermoduls.

Ein Vorteil des Verfahrens zur Lebensdauersteuerung ist dadurch gegeben, dass eine unvorhergesehene Alterung kurz vor dem geplanten Austausch des Energiespeichermoduls, d.h. kurz vor seinem Lebensdauerende vermieden werden kann. Der vorausschauende Charakter des Verfahrens zur Lebensdauersteuerung erlaubt die Steuerung, insbesondere die Verlängerung der Lebensdauer des Energiespeichermoduls, und ermöglicht darüber hinaus einen Betrieb des Energiespeichermoduls, der einen Ausfall kurz vor dem geplanten Lebensdauerende verhindert oder zumindest unwahrscheinlich macht.

Bei vielen Energiespeichern ist ein Recovery-Effekt des SoH-Wertes zu beobachten. Dieser wird durch das hier verwendete Verfahrene ausgeblendet, wenn der Betrachtungszeitraum und damit die in dem Betrachtungszeitraum liegenden Alterungszustände für die Bestimmung der Alterungsgeschwindigkeit geeignet gewählt werden. Dabei hat es sich als sinnvoll erwiesen, die Berechnung der Alterungsgeschwindigkeit erst dann durchzuführen, wenn eine initiale Anfangsphase des Energiespeicherbetriebs abgelaufen ist, in der der Recovery-Effekt wirkt. Während der Recovery-Phase erfolgt die Alterung des Energiespeichermoduls nicht linear und weicht somit von einer berechneten konstanten Alterungsgeschwindigkeit teilweise sogar deutlich ab. Eine darauf aufsetzende Berechnung des Zeitpunktes des Lebensdauerendes ist somit fehlerbehaftet und teilweise sehr ungenau. Somit hat es sich als günstig erwiesen, die ersten Messwerte für den Alterungszustand nach Beginn des Betriebs des Energiespeichermoduls nicht für die Berechnung der Alterungsgeschwindigkeit heranzuziehen. Erst wenn das Energiespeichermodul einige Zeit, beispielsweise je nach Anwendungsfall eine Minute, zehn Minuten oder eine Stunde im Betrieb ist, werden die ermittelten Alterungszustände zur Bestimmung der Alterungsgeschwindigkeit herangezogen. Alternativ können die ersten Alterungszustände mit einem Gewichtungsfaktor versehen werden, so dass deren Einfluss auf die Berechnung der Alterungsgeschwindigkeit, insbesondere bei der Berechnung über statistische Verfahren der Mathematik, geringer ist. Damit kann eine Berechnung des Zeitpunkts für das Lebensdauerende genauer erfolgen.

Bei einer vorteilhaften Ausgestaltung der Erfindung wird in Abhängigkeit von der Größe des Zeitintervalls zwischen einem Zeitpunkt eines geplanten Lebensdauerendes und dem Zeitpunkt des ermittelten Lebensdauerendes eine Maßnahme zur Veränderung der Lebensdauer des Energiespeichermoduls angewendet. Damit steht der Regelung oder Steuerung ein Auswahlkriterium zur Verfügung, wann es sinnvoll ist oder sein kann, lebensdauerverlängernde Maßnahmen für das Energiespeichermodul einzuleiten. Dazu wird beispielsweise im Vorfeld während der Auslegung des Energiespeichermoduls der zeitliche Verlauf des Alterungszustandes als Funktion von der Zeit unter bestimmten Auslegungsbedingungen oder Umgebungsbedingungen sowie Einsatzbedingungen oder Einsatzszenarien berechnet oder simuliert. Über diesen zeitlichen Verlauf kann auch der Zeitpunkt des geplanten Lebensdauerendes bestimmt werden. Die Simulation kann dabei rechnerisch oder auf Basis von Versuchen, sowie in Kombination durchgeführt werden. Dabei ist der Verlauf des Alterungszustands über der Zeit nicht unbedingt linear. Es hat sich gezeigt, dass gerade in einer Anfangszeit der Verlauf nicht linear ist und erst ab einem bestimmten Zeitpunkt in einen linearen Verlauf übergeht. Aus der Berechnung bzw. Simulation ergibt sich unter anderem dieser Zeitpunkt, ab dem die Alterung, d.h. die Veränderung der Alterungsgeschwindigkeit, nahezu linear verläuft. Erst ab diesem Zeitpunkt ist das Verfahren aufgrund seiner dann vorhandenen Genauigkeit besonders vorteilhaft. Darüber hinaus kann auch der Recovery-Effekt, der oftmals zu einer Berechnung eines zu frühen Zeitpunkts des Lebensdauerendes führen würde, kompensiert werden. Somit liefert die Berechnung des Zeitpunkts des ermittelten Lebensdauerendes über die Alterungsgeschwindigkeit ein wesentlich genaueres Ergebnis als bisher bekannte Verfahren für die Steuerung der Lebensdauer eines Energiespeichermoduls.

Dabei hat es sich als vorteilhaft erwiesen, dass auf einfache Weise die Leistungsfähigkeit eines Energiespeichermoduls dadurch erhöht werden kann, dass der Zeitpunkt für das geplante Lebensdauerende zu einem früheren Zeitpunkt hin verschoben wird. Dies erlaubt eine stärkere Belastung des Energiespeichermoduls, beispielsweise durch höhere Ströme, höhere Anzahl an Zyklen oder einer höheren Umgebungstemperatur. Dadurch kann auch nach Auslieferung einer Anlage oder eines Fahrzeugs in vielen Fällen auf einfache Weise eine zusätzliche oder eine neue Kundenanforderung nach erhöhter Leistungsfähigkeit einfach realisiert werden, indem lediglich ein Parameter, beispielsweise der Wert des Zeitpunkts des geplanten Lebensdauerendes, angepasst wird. Bei dieser Anpassung wird der Wert des Zeitpunkts des geplanten Lebensdauerendes auf einen früheren Zeitpunkt gelegt.

Die Kenntnis über den Zeitpunkt des ermittelten Lebensdauerendes kann dazu genutzt werden, Wartungsmaßnahmen für die Anlage oder das Fahrzeug genauer planen zu können, da diese hinreichend genau und frühzeitig bekannt sind. Dies vereinfacht die Logistik über Planung des Fahrzeugeinsatzes sowie die Organisation der Wartung von Durchführung bis zur Ersatzteilbeschaffung.

Bei einer weiteren vorteilhaften Ausgestaltung der Erfindung wird für den Fall, dass der Zeitpunkt des ermittelten Lebensdauerendes vor dem Zeitpunkt des geplanten Lebensdauerendes liegt, eine Maßnahme zur Veränderung der Lebensdauer angewendet, wobei die Maßnahme zur Veränderung der Lebensdauer eine Maßnahme zur Verlängerung der Lebensdauer ist. Ein besonders günstiges Energiespeichermodul ist dadurch herstellbar, wenn keine Überdimensionierung oder Reserven bei der Auslegung berücksichtigt werden. Um gleichzeitig jedoch einen Ausfall bzw. ein Erreichen des Lebensdauerendes vor dem geplanten Lebensdauerende zu verhindern, werden bei einem hohen Lebensdauerverbrauch, d.h. bei einer hohen Alterungsgeschwindigkeit, erkennbar an einem frühen Zeitpunkt des ermittelten Lebensdauerendes, Maßnahmen zur Verlängerung der Lebensdauer durch die Regelung oder Steuerung des Energiespeichermoduls veranlasst. Dabei kann bei nur leichten Einschränkungen im Betrieb eine Verlängerung des Betriebs des Energiespeichermoduls erreicht werden. Es hat sich gezeigt, dass im Betrieb des Fahrzeugs oder der Anlage das Energiespeichermodul deutlich weniger stark ausgenutzt oder belastet wird als gefordert. Diese Auslegungsreserven können für eine Verlängerung der Lebensdauer genutzt werden. Dabei führt häufig eine Steuerung der Lebensdauer noch nicht zu Einschränkungen im Betrieb oder zu einer Verringerung des Wirkungsgrades des Systems.

Bei einer weiteren vorteilhaften Ausgestaltung der Erfindung wird in Abhängigkeit von mindestens einem Betriebsparameter des Energiespeichermoduls und/oder mindestens einer Umgebungsbedingung unter Zuhilfenahme von in einem Speicher abgelegten Daten der Betrieb des Energiespeichermoduls derart gesteuert oder geregelt, dass zur Veränderung der Lebensdauer des Energiespeichermoduls eine Kühlleistung des Energiespeichermoduls verändert wird und/oder eine Betriebsstrategie des Energiespeichermoduls geändert wird und/oder eine Betriebsgröße des Energiespeichermoduls limitiert wird. Es hat sich gezeigt, dass es für die Veränderung der Lebensdauer des Energiespeichers vorteilhaft ist, die genannten Maßnahmen in Abhängigkeit von einem oder mehreren Betriebsparametern oder einem oder mehreren Umgebungsbedingungen zu realisieren. Dabei hat es sich als vorteilhaft erwiesen, für die Auswahl geeigneter Maßnahmen, Entscheidungskriterium wie beispielsweise eine Veränderung des Wirkungsgrades in einem Datenspeicher (look up table) zu hinterlegen und für die Entscheidung über die Maßnahme heranzuziehen und nicht die Auswirkung der Maßnahme online zu berechnen. Mit der Hinterlegung kann ohne viel Rechenleistung ein gutes Verhalten bei Einleiten von lebensdauerverlängernden Maßnahmen realisiert werden.

Die Maßnahmen können in die oben genannten Gruppen unterteilt werden. Bei der Kühlleistungserhöhung kann beispielsweise der Durchsatz des Kühlmediums bzw. des Kühlmittels erhöht werden. Dies geschieht auf einfache Weise beispielsweise bei einer Luftkühlung durch Erhöhung der Lüfterdrehzahl oder bei einer Flüssigkeitskühlung durch Erhöhung der Pumpleistung. Darüber hinaus besteht alternativ oder ergänzend noch die Möglichkeit, die Temperatur des Kühlmediums zu reduzieren. Dies kann beispielsweise bei einer Luftkühlung durch ein Klimagerät geschehen, welches die Temperatur der Kühlluft absenken kann, oder bei einer Flüssigkeitskühlung durch Erhöhung der Leistungsfähigkeit eines Rückkühlers, der die in der Kühlflüssigkeit enthaltene Wärme an die Umgebungsluft abführt.

Die Änderung der Betriebsstrategie betrifft Punkte, welche eine Belastung des Energiespeichermoduls verursachen, aber nicht unbedingt direkt mittels eines Sensors aus elektrischen Größen gemessen werden. Dazu zählt beispielsweise, die Beschleunigung eines Fahrzeugs zu verringern. Ebenso ist es möglich, die Anzahl von Zyklen, die sich aus Ladung und Entladung für den Energiespeicher ergeben, zu verringern. Die Verringerung dieser Zyklenzahl wird beispielsweise dadurch erreicht, dass ein Energiespeichermodul erst dann entladen wird, wenn es einen bestimmten vorgebbaren minimalen Ladezustand erreicht hat.

Die Limitierung von Betriebsgrößen betrifft die von einem Sensor messbaren Größen, insbesondere elektrische Größen. Dazu zählt insbesondere der Strom durch das Energiespeichermodul. Da der Strom eine direkte Auswirkung auf die Temperatur und somit auch auf die Lebensdauer des Energiespeichers hat, ist diese Maßnahme besonders effektiv. Allerdings bringt diese auch eine hohe Einschränkung für den Betrieb des Energiespeichermoduls mit sich.

Bei der erfindungsgemäßen Ausgestaltung der Erfindung wird die Kühlleistung des Energiespeichermoduls gesteigert, wenn eine im Energiespeichermodul gemessene Temperatur größer ist als ein gemittelter oder geglätteter Wert der im Energiespeichermodul gespeicherten Temperatur und/oder wenn eine gemessene Umgebungstemperatur größer ist als ein gemittelter oder geglätteter Wert der gemessenen Umgebungstemperatur. Es hat sich als positiv erwiesen, wenn die Kühlleistung bei einer hohen Temperatur des Energiespeichermoduls und/oder Umgebungstemperatur gesteigert wird. Eine hohe Temperatur sowohl im Energiespeichermodul als auch in der Umgebung ist daran zu erkennen, wenn diese oberhalb ihres gemittelten oder geglätteten Wertes liegt. Dabei kann die Kühlleistung direkt bei

Überschreiten dieses gemittelten oder geglätteten Wertes erhöht werden, oder wenn der gemittelte oder geglättete Wert um einen vorgebbaren Wert überschritten wird.

Der gemittelte Wert wird dadurch berechnet, dass über ein festgelegtes Zeitfenster der Mittelwert dieser Werte gebildet wird. Oftmals einfacher als eine Mittelung lässt sich innerhalb der Regelung eine Glättung durchführen. Bei dieser Glättung wird das Temperatursignal beispielsweise auf einfache Weise durch ein PT1-Glied geglättet. Im Vergleich zur Mittelwertbildung ist der erforderliche Speicher deutlich geringer.

Ein besonderer Vorteil dieser Ausgestaltungsform liegt darin, dass die Kühlung insbesondere zu den Zeiten besonders erhöht wird, wenn eine hohe Temperatur und damit eine hohe Belastung vorliegen. Somit kann durch eine einfache Maßnahme, die den Betrieb der Anlage bzw. des Fahrzeugs nicht oder nahezu nicht beeinträchtigt, die Lebensdauer des Energiespeichermoduls verlängert werden.

Bei einer weiteren vorteilhaften Ausgestaltung der Erfindung wird die Kühlleistung in Abhängigkeit der Differenz zwischen der im Energiespeichermodul gemessenen Temperatur und der gemessenen Umgebungstemperatur gesteigert. Mit der Steigerung der Kühlleistung wird gerade bei einer großen Abweichung der im Energiespeichermodul gemessenen Temperatur von der Umgebungstemperatur dem dann vorhandenen Lebensdauerverlust entgegengetreten. Aufgrund des hohen Temperaturunterschiedes ist die Steigerung der Kühlleistung im Falle der Erhöhung des Kühlmitteldurchflusses besonders effektiv. Dabei hat es sich als besonders günstig erwiesen, wenn die Erhöhung der Kühlleistung linear oder quadratisch zur Temperaturdifferenz zwischen der im Energiespeichermodul gemessenen Temperatur und der gemessenen Umgebungstemperatur erfolgt.

Bei einer weiteren vorteilhaften Ausgestaltung der Erfindung wird die Betriebsstrategie des Energiespeichers dahingehend geändert, dass der maximale Ladezustand gesenkt wird und/oder die minimale Entladetiefe erhöht wird. Die Belastung eines Energiespeichermoduls ist gerade an seinen Grenzen des Ladungszustands relativ hoch. Bei maximaler Ladung ist insbesondere bei der Verwendung von Doppelschichtkondensatoren die Spannung, insbesondere die Spannung der der einzelnen Kondensatorzellen, recht hoch und stellt damit eine Belastung, d.h. erhöhte Alterung, für das Energiespeichermodul dar. Bei minimaler Ladung sinkt die Spannung und es ist zum Austausch einer bestimmten Energiemenge ein höherer Strom notwendig, der zu einer größeren Erwärmung und damit zu einer höheren Belastung des Energiespeichermoduls führt. Durch eine Verringerung der im Energiespeichermodul speicherbaren Energiemenge, durch Anhebung der minimalen Entladetiefe (DoD) und/oder Absenkung des maximalen Ladezustands (SoC) kann die Belastung des Energiespeichermoduls auf einfache Weise verringert und die Lebensdauer erhöht werden. Diese Art der Maßnahme ist ein Beispiel für die Änderung der Betriebsstrategie.

Bei einer weiteren vorteilhaften Ausgestaltung der Erfindung wird die Betriebsstrategie des Energiespeichermoduls dahingehend geändert, dass die Anzahl der Zyklen reduziert wird. Um die Lebensdauer eines Energiespeichermoduls zu erhöhen, hat es sich als günstig erwiesen, die Anzahl der Zyklen, d.h. die Abfolge von Lade- und Entladevorgänge, zu reduzieren. Dies kann auf einfache Weise dadurch geschehen, dass im Falle einer Ladung des Energiespeichermoduls dieses Modul erst dann wieder entladen wird, wenn das Energiespeichermodul eine bestimmte Mindestmenge an elektrischer Energie gespeichert hat. Erst nach Erreichen dieses Wertes wird der Energiespeicher wieder entladen. Damit werden Ladezyklen, die nur einen geringen Energieaustausch bewirken, d.h. nur einen geringen Energiehub haben, und trotzdem sich zum Teil deutlich negativ auf die Lebensdauer des Energiespeichermoduls auswirken, vermieden. Trotzdem kann das Fahrzeug oder die Anlage rückgespeiste Energie, z.B. während eines Bremsvorgangs jederzeit in das Energiespeichermodul einbringen und die Energie umweltfreundlich speichern. Lediglich das Bereitstellen von Energie durch das Energiespeichermodul wird damit zu einigen Zeitpunkten, wie beispielsweise in einem Beschleunigungsvorgang, unterbunden. Somit kann überschüssige Energie aus dem Antrieb durch den Energiespeicher aufgenommen werden, so dass seine positiven Eigenschaften in Bezug auf Umweltfreundlichkeit erhalten bleiben, da überschüssige Energie nicht in Wärme umgewandelt bzw. vernichtet werden muss.

Bei einer weiteren vorteilhaften Ausgestaltungsform wird der durch das Energiespeichermodul fließende Strom limitiert. Dieser Strom bewirkt durch seine ohmschen Verluste im Energiespeicher eine Erwärmung innerhalb des Energiespeichers. Diese Erwärmung wirkt sich negativ auf die Lebensdauer des Energiespeichers aus. Dies geschieht umso stärker, je wärmer das Energiespeichermodul ist. Somit kann durch die Limitierung des durch das Energiespeichermodul fließenden Stroms eine Erwärmung und damit eine Belastung des Energiespeichers, die zu einer Verringerung der Lebensdauer führt, auf einfache Weise reduziert werden.

Bei einer weiteren vorteilhaften Ausgestaltung der Erfindung wird der Entladestrom des Energiespeichermoduls limitiert. Wenn nur der Entladestrom begrenzt wird und der Ladestrom keiner Limitierung unterliegt, kann das Energiespeichermodul weiterhin unverändert Energie. Damit kann sichergestellt werden, dass keine elektrische Energie, beispielsweise über einen Bremswiderstand, in Wärme umgewandelt wird, sondern für eine weitere Nutzung im Antrieb zur Verfügung steht. Somit bleibt der Wirkungsgrad der Anlage oder des Fahrzeugs, insbesondere des Antriebs des Fahrzeugs, auch bei dieser lebensdauererhöhenden Maßnahme weiterhin hoch. Trotz des Wirkens dieser lebensdauerverlängernden Maßnahme ist die Umweltfreundlichkeit des Energiespeichermoduls weiterhin gegeben, da keine Energie in Wärme umgewandelt werden muss. Damit ist ein erhöhter Energieverbrauch oder gar eine Energieverschwendung trotz des Wirkens der lebensdauerverlängernden Maßnahmen ausgeschlossen. Der Wirkungsgrad des Gesamtsystems ist daher nahezu unverändert hoch. Lediglich die Leistungsfähigkeit, beispielsweise bei der Beschleunigung eines Fahrzeugs, ist durch diese Maßnahme eingeschränkt, ohne jedoch den Gesamtwirkungsgrad der Anlage deutlich zu verschlechtern.

Im Folgenden wird die Erfindung anhand der in den Figuren dargestellten Ausführungsbeispiele näher beschrieben und erläutert. Es zeigen:
- FIG 1: ein Blockschaltbild einer Regelung,
- FIG 2: den Verlauf des Alterungszustands über der Zeit,
- FIG 3: Berechnung des geplanten Lebensdauerendes,
- FIG 4: eine erste Maßnahme zur Steigerung der Lebensdauer,
- FIG 5: eine weitere Maßnahme zur Steigerung der Lebensdauer und
- FIG 6: eine Absenkung des maximalen Ladezustands.

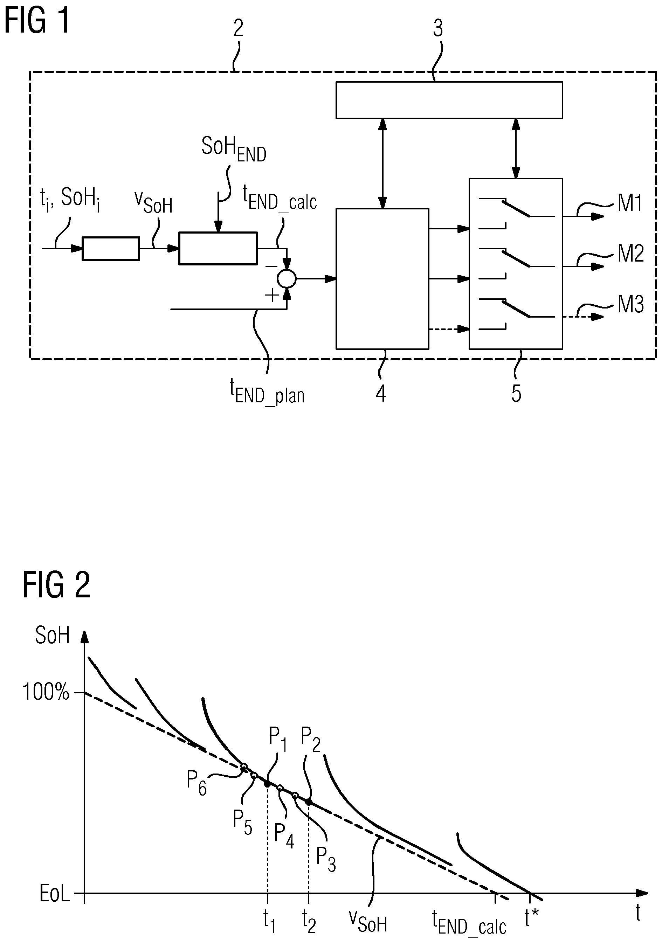

FIG 1 zeigt das Blockschaltbild einer Steuerung zur Beeinflussung der Lebensdauer eines hier nicht dargestellten Energiespeichermoduls 1. Als Eingangsgrößen dieser Regelung dienen die Signale über den Alterungszustand SoHᵢ des Energiespeichermoduls 1 zu unterschiedlichen Zeitpunkten tᵢ. Die einzelnen Alterungszustände SoHᵢ können beispielsweise über den Innenwiderstand oder der Kapazität des Energiespeichermoduls 1 bestimmt werden. Aus mindestens zwei der Alterungszustände SoHᵢ und den dazugehörigen Zeitpunkten tᵢ kann die Alterungsgeschwindigkeit v_{SoH} ermittelt werden. Diese erhält man beispielsweise dadurch, dass die Differenz zweier Alterungszustände SoHᵢ durch die Differenz der dazugehörigen Zeitpunkte tᵢ geteilt wird. Weitere Alterungszustände SoHᵢ können dazu genutzt werden, die Bestimmung der Alterungsgeschwindigkeit beispielsweise in Bezug auf Genauigkeit zu verbessern. Neben der Berechnung der Alterungsgeschwindigkeit v_{SoH} über die Differenz zweier Alterungszustände SoHᵢ hat es sich ebenfalls als sinnvoll erwiesen, die Alterungsgeschwindigkeit v_{SoH} über statistische Verfahren wie beispielsweise über Medianwerte zu bestimmen. Die Vielzahl der an der Bestimmung beteiligten Alterungszustände SoHᵢ verbessert dabei die Bestimmung der Alterungsgeschwindigkeit v_{SoH}. Aus der Alterungsgeschwindigkeit v_{SoH} kann der Zeitpunkt t_{END_calc} des ermittelten Lebensdauerendes bestimmt werden, wenn der Berechnung ein Alterungszustand SoH_{END} vorgegeben wird, an dem das Energiespeichermodul auszutauschen ist, d.h. das Ende seiner Lebensdauer (EoL, End of Lifetime) erreicht hat. Anhand eines Vergleichs zwischen dem ermittelten Lebensdauerende t_{END_calc} und einem geplanten Lebensdauerende t_{END_plan} kann entschieden werden, ob Maßnahmen zur Beeinflussung der Lebensdauer angewendet werden. Dies hat sich insbesondere dann als vorteilhaft erwiesen, wenn das geplante Lebensdauerende t_{END_plan} zeitlich hinter, d.h. nach dem ermittelten Lebensdauerende t_{END_calc} liegt.

Die Differenz zwischen dem Zeitpunkt t_{END_calc} des ermittelten Lebensdauerendes und einem Zeitpunkt t_{END_plan} eines geplanten Lebensdauerendes wird als Regelabweichung einer Entscheidungseinheit 4 übermittelt. Zur Beeinflussung der Lebensdauer des Energiespeichermoduls 1 durch diese Entscheidungseinheit 4 werden zuvor abgelegte Daten aus einem Datenspeicher 3 herangezogen, um eine geeignete Maßnahme M1, M2, M3 zur Veränderung der Lebensdauer auszuwählen. Dabei kann beispielsweise der Betriebszustand des Energiespeichermoduls oder der Anlage bzw. des Fahrzeugs herangezogen werden, um eine oder mehrere Maßnahmen aus den zur Verfügung stehenden Maßnahmen M1, M2, M3 auszuwählen, die eine möglichst geringe Auswirkung auf den Betrieb hat. Die Maßnahmen M1, M2, M3 werden deshalb vorzugsweise über eine offline ermittelte Datenbasis (Energieverlustberechnung, Lookup table) in Abhängigkeit von der Regelabweichung ausgewählt. Die Datenbasis ist in dem Datenspeicher 3 hinterlegt und stellt sicher, dass der Gesamtwirkungsgrad der Anlage wenig beeinflusst bzw. herabgesetzt wird. Darüber hinaus hat es sich als vorteilhaft erwiesen, die Maßnahmen M1, M2, M3 dann wirken zu lassen, wenn sie die Lebensdauer am wirkungsvollsten verändern, insbesondere verlängern, und gleichzeitig mit minimalem Energieverlust verbunden sind. Auch dieses Entscheidungskriterium kann im Datenspeicher hinterlegt werden. Die einzelne Maßnahme Mᵢ oder auch mehrere Maßnahmen M1, M2, M3 werden dabei durch das Mittel 5 zur Umsetzung von Maßnahmen initiiert.

FIG 2 zeigt ein Beispiel für die Bestimmung der Alterungsgeschwindigkeit v_{SoH}, d.h. die Bestimmung der Steigung im Verlauf des Alterungszustands SoH über der Zeit t. In diesem Ausführungsbeispiel werden dazu die Alterungszustände SoHᵢ an den Punkten P₁ und P₂ herangezogen. Aus diesen wird eine Gerade bestimmt, dessen Steigung der Alterungsgeschwindigkeit v_{SoH} entspricht. Der Alterungszustand SoH verläuft dabei nicht linear über die Zeit t. Vielmehr schwankt der Alterungszustand SoH, wobei es immer wieder Phasen der Erholung des Energiespeichermoduls 1 gibt, an denen der Alterungszustand einen höheren Wert annimmt. Diese Phasen treten beispielsweise während Betriebspausen, insbesondere längeren Betriebspausen, auf. Diese Phasen werden auch als Recovery-Effekt bezeichnet. Für die Berechnung der Alterungsgeschwindigkeit v_{SoH} ist es günstig, Punkte Pᵢ zu verwenden, an denen der Effekt der Erholung bereits abgeklungen ist. Darüber hinaus ist es günstig, den Abstand der für die Bestimmung der Alterungsgeschwindigkeit v_{SoH} weder zu groß noch zu klein zu wählen, um das Rechenergebnis unabhängig von Messtoleranzen zu gestalten.

Aus dem Schnittpunkt der Geraden mit der Achse EoL des Endes der Lebensdauer wird der Zeitpunkt T_{END_calc} des Endes der ermittelten Lebensdauer bestimmt. Dieser kann beispielsweise aufgrund von Messfehlern vom tatsächlichen Zeitpunkt t* für das Ende der Lebensdauer abweichen.

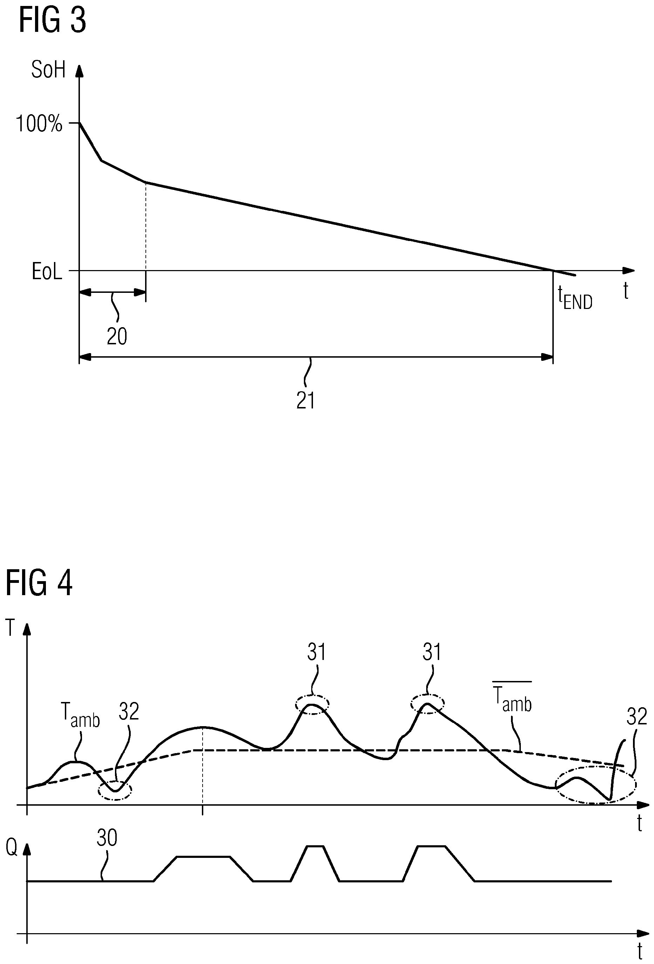

Einen typischen Verlauf für den Alterungszustand SoH eines Energiespeichermoduls 1 über der Zeit t zeigt FIG 3. Dieser kann für ein Energiespeichermodul 1 sowohl rechnerisch als auch aus Versuchen bestimmt werden. Die Lebensdauer 21 umfasst dabei die Zeitspanne von Beginn des Betriebs des Energiespeichermoduls 1, an dem es einen Alterungszustand von 100% aufweist, bis zum Zeitpunkt t_{END} des Lebensdauerendes. Zu Beginn des Betriebs weist diese Kennlinie einen nichtlinearen Bereich 20 auf. Es hat sich als vorteilhaft erwiesen, Messwerte des Alterungszustands SoH nur außerhalb des nichtlinearen Bereichs 20 für die Bestimmung der Alterungsgeschwindigkeit v_{SoH} heranzuziehen, da Messwerte innerhalb des nichtlinearen Bereichs 20 zu einem rechnerisch zu frühen Lebensdauerende führen würde.

FIG 4 zeigt als Beispiel für eine Maßnahme zur Verlängerung der Lebensdauer des Energiespeichermoduls 1 den zeitlichen Verlauf der Umgebungstemperatur T_{amb} und den zeitlichen Verlauf 30 des Kühlmitteldurchsatzes Q. Dabei hat es sich als günstig erwiesen, in Bereichen 31 mit hoher Temperatur T den Kühlmitteldurchsatz Q zu erhöhen. Als Bereiche 31 mit hoher Temperatur gelten beispielsweise Temperaturwerte T die oberhalb einer gemittelten oder geglätteten Umgebungstemperatur **T̅_̅{̅a̅m̅b̅}̅** liegen oder die den gemittelten oder geglätteten Wert der Umgebungstemperatur **T̅_̅{̅a̅m̅b̅}̅** um einen bestimmten Wert oder einen bestimmten Faktor überschreiten. Dabei hat es sich als günstig erwiesen, abhängig von der Differenz zwischen der Umgebungstemperatur und der gemittelten oder geglätteten Umgebungstemperatur **T̅_̅{̅a̅m̅b̅}̅** Den Kühlmitteldurchsatz Q zu erhöhen.

Ergänzend dazu kann in Bereichen 32 niedriger Umgebungstemperatur, wie beispielsweise im Winter oder in der Nacht, die Kühlleistung reduziert werden. Aus Gründen der Übersichtlichkeit wurde eine Reduzierung der Kühlleistung in der FIG 4 nicht dargestellt.

Die Erhöhung des Kühlmitteldurchsatzes Q kann beispielsweise bei einer Luftkühlung durch die Erhöhung einer Lüfterdrehzahl erreicht werden. Bei einer Flüssigkeits- oder Wasserkühlung kann die Erhöhung des Kühlmitteldurchsatzes Q beispielsweise durch die Erhöhung der Pumpleistung erzielt werden.

Alternativ zur Umgebungstemperatur T_{amb} kann auch die Temperatur T_{ES} des Energiespeichers bzw. eine Temperatur innerhalb des Energiespeichers für die Steuerung oder Regelung des Kühlmitteldurchsatzes Q verwendet werden.

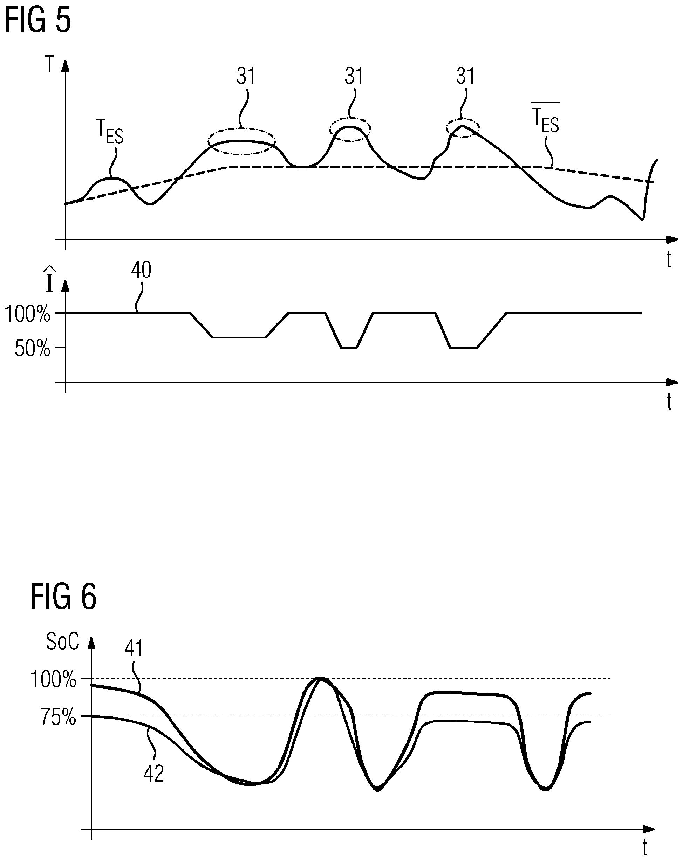

Eine Reduzierung des Strommaximalwertes **Î** in Abhängigkeit von der Temperatur im Energiespeicher T_{ES} zeigt FIG 5. Dazu ist der Verlauf 40 des Strommaximalwertes **Î** dargestellt. Im Bereich 31 hoher Temperaturen T wird der Strommaximalwert **Î** des Stromes I durch das Energiespeichermodul 1 reduziert. Als Bereiche 31 hoher Temperaturen T gelten insbesondere Zeitpunkte, an denen die Temperatur im Energiespeicher T_{ES} den gemittelten oder geglätteten Wert dieser Temperatur **T̅_̅{̅a̅m̅b̅}̅** übersteigt oder um einen bestimmten Wert oder Faktor übersteigt. Der Grad der Reduzierung kann dabei abhängig von der Differenz zwischen der Temperatur im Energiespeicher T_{ES} und dem gemittelten oder geglätteten Wert dieser Temperatur **T̅_̅{̅a̅m̅b̅}̅** abhängig gemacht werden.

Eine alternative Maßnahme zur Beeinflussung der Lebensdauer des Energiespeichermoduls 1 besteht darin, den Ladezustand SoC des Energiespeichers zu beschränken. Dazu kann der maximale Ladezustand SoCₘₐₓ von einem Wert von 100% auf einen reduzierten Wert von beispielsweise 75% abgesenkt werden. FIG 6 zeigt dabei den ersten zeitlichen Verlauf 41 eines Ladezustands SoC, der keiner Beschränkung des maximalen Ladezustands SoCₘₐₓ unterliegt (d.h. SoCₘₐₓ=100%) und einen zweiten zeitlichen Verlauf 42 eines Ladezustands SoC, der einer Beschränkung des maximalen Ladezustands SoCₘₐₓ unterliegt (beispielsweise SoCₘₐₓ=75%). Dabei hat es sich als vorteilhaft erwiesen, auch im Falle der Beschränkung des maximalen Ladezustands SoCₘₐₓ kurzzeitig einen Ladezustand zu erlauben, der den maximalen Ladezustand SoCₘₐₓ überschreitet, da sich eine nur kurzfristige Überschreitung nur unwesentlich auf die Lebensdauer des Energiespeichermoduls 1 auswirkt, aber gleichzeitig den Wirkungsgrad des Energiespeichersystems hoch hält.

Zusammenfassend betrifft die Erfindung ein Verfahren zur Steuerung der Lebensdauer eines Energiespeichermoduls, wobei zu unterschiedlichen Zeitpunkten ein Alterungszustand des Energiespeichermoduls bekannt ist. Zur Verbesserung der Steuerung der Lebensdauer eines Energiespeichermoduls wird vorgeschlagen, dass aus einem ersten bekannten Alterungszustand, in dem sich das Energiespeichermodul zu einem ersten Zeitpunkt befindet, und einem zweiten Alterungszustand, in dem sich das Energiespeichermodul zu einem zweiten Zeitpunkt befindet, eine Alterungsgeschwindigkeit ermittelt wird, wobei aus der Alterungsgeschwindigkeit und einem der Alterungszustände ein Zeitpunkt eines ermittelten Lebensdauerendes berechnet wird, wobei in Abhängigkeit von dem Zeitpunkt des ermittelten Lebensdauerendes eine Maßnahme zur Veränderung der Lebensdauer des Energiespeichermoduls angewendet wird.

## Patentansprüche

1. Verfahren zur Steuerung der Lebensdauer eines Energiespeichermoduls (1), wobei zu unterschiedlichen Zeitpunkten (t) ein Alterungszustand (SoH) des Energiespeichermoduls (1) bekannt ist, wobei ein erster Alterungszustand (SoH₁) bekannt ist, in dem sich das Energiespeichermodul (1) zu einem ersten Zeitpunkt (t₁) befindet, und ein zweiter Alterungszustand (SoH₂) bekannt ist, in dem sich das Energiespeichermodul (1) zu einem zweiten Zeitpunkt (t₂) befindet, wobei aus dem ersten und dem zweiten Alterungszustand (SoH₁, SoH₂) und dem ersten und dem zweiten Zeitpunkt (t₁,t₂) eine Alterungsgeschwindigkeit (v_{SoH}) ermittelt wird, wobei aus der Alterungsgeschwindigkeit (v_{SoH}) und einem der Alterungszustände (SoH) ein Zeitpunkt (t_{END_calc}) eines ermittelten Lebensdauerendes berechnet wird, wobei in Abhängigkeit von dem Zeitpunkt (t_{END_calc}) des ermittelten Lebensdauerendes eine Maßnahme zur Veränderung der Lebensdauer des Energiespeichermoduls (1) angewendet wird, wobei das Energiespeichermodul (1) Doppelschichtkondensatoren umfasst,
**dadurch gekennzeichnet, dass** die Kühlleistung des Energiespeichermoduls (1) gesteigert wird, wenn eine im Energiespeichermodul (1) gemessene Temperatur (T_{ES}) größer ist als ein gemittelter oder geglätteter Wert der im Energiespeichermodul gemessenen Temperatur (**T̅_̅{̅E̅S̅}̅**) und/oder wenn eine gemessene Umgebungstemperatur (T_{amb}) größer ist als ein gemittelter oder geglätteter Wert der gemessenen Umgebungstemperatur (**T̅_̅{̅a̅m̅b̅}̅**).

2. Verfahren nach Anspruch 1, wobei in Abhängigkeit von der Größe des Zeitintervalls zwischen einem Zeitpunkt (t_{END_plan}) eines geplanten Lebensdauerendes und dem Zeitpunkt (t_{END_calc}) des ermittelten Lebensdauerendes eine Maßnahme zur Veränderung der Lebensdauer des Energiespeichermoduls (1) angewendet wird.

3. Verfahren nach einem der Ansprüche 1 oder 2, wobei für den Fall, dass der Zeitpunkt (t_{END_calc}) des ermittelten Lebensdauerendes vor dem Zeitpunkt (t_{END_plan}) des geplanten Lebensdauerendes liegt, eine Maßnahme zur Veränderung der Lebensdauer angewendet wird, wobei die Maßnahme zur Veränderung der Lebensdauer eine Maßnahme zur Verlängerung der Lebensdauer ist.

4. Verfahren nach einem der Ansprüche 1 bis 3, wobei in Abhängigkeit von mindestens einem Betriebsparameter des Energiespeichermoduls (1) und/oder mindestens einer Umgebungsbedingung unter Zuhilfenahme von in einem Speicher abgelegten Daten der Betrieb des Energiespeichermoduls (1) derart gesteuert oder geregelt wird, dass zur Veränderung der Lebensdauer des Energiespeichermoduls
- die Kühlleistung des Energiespeichermoduls (1) verändert wird und/oder
- eine Betriebsstrategie des Energiespeichermoduls (1) geändert wird und/oder
- eine Betriebsgröße des Energiespeichermoduls limitiert wird.

5. Verfahren nach Anspruch 1, wobei die Kühlleistung in Abhängigkeit der Differenz zwischen der im Energiespeichermodul (1) gemessenen Temperatur (T_{ES}) und der gemessenen Umgebungstemperatur (T_{amb}) gesteigert wird.

6. Verfahren nach einem der Ansprüche 1 bis 5, wobei die Betriebsstrategie des Energiespeichermoduls (1) dahingehend geändert wird, dass der maximale Ladezustand (SoCₘₐₓ) gesenkt wird und/oder die minimale Entladetiefe (DoDₘᵢₙ) erhöht wird.

7. Verfahren nach einem der Ansprüche 1 bis 6, wobei die Betriebsstrategie des Energiespeichermoduls (1) dahingehend geändert wird, dass die Anzahl der Zyklen reduziert wird.

8. Verfahren nach einem der Ansprüche 1 bis 7, wobei der durch das Energiespeichermodul (1) fließende Strom (I) limitiert wird.

9. Verfahren nach Anspruch 8, wobei der Entladestrom (I_{dis}) des Energiespeichermoduls (1) limitiert wird.

10. Verfahren zur Steuerung der Lebensdauer einer Vielzahl von Energiespeichermodulen (1), wobei mindestens ein erstes Energiespeichermodul (11) der Vielzahl von Energiespeichermodulen (1) mit einem ersten Zeitpunkt (t_{END_calc, 1}) des ermittelten Lebensdauerendes mittels eines Verfahrens nach einem der Ansprüche 1 bis 9 derart geregelt werden, dass der erste Zeitpunkt (t_{END_calc,1}) des ermittelten Lebensdauerendes sich einem vorgebbaren Zeitpunkt annähert.

11. Verfahren nach Anspruch 10, wobei das erste Energiespeichermodul (11) mit dem ersten Zeitpunkt (t_{END_calc, 1}) des ermittelten Lebensdauerendes, der zeitlich früher liegt als ein zweiter Zeitpunkt (t_{END_calc, 2}) des ermittelten Lebensdauerendes eines zweiten Energiespeichermoduls (12) der Vielzahl von Energiespeichermodulen (1), derart geregelt oder gesteuert wird, dass sich die Lebensdauer des ersten Energiespeichermoduls (11) verlängert.

12. Verfahren nach einem der Ansprüche 10 oder 11, wobei die einzelnen Energiespeichermodule (1) jeweils derart geregelt werden, dass die jeweiligen Zeitpunkte (t_{END_calc,i}) des ermittelten Lebensdauerendes der einzelnen Energiespeichermodule (1) sich einander annähern.

13. Steuerung (2) für ein Energiespeichermodul (1) mit Mitteln zur Durchführung eines Verfahrens nach einem der Ansprüche 1 bis 12, wobei das Energiespeichermodul (1) Doppelschichtkondensatoren umfasst.

14. Programm zur Durchführung eines Verfahrens nach einem der Ansprüche 1 bis 12 bei Ablauf in einer Steuerung nach Anspruch 13.

15. Computerprogrammprodukt mit einem Programm nach Anspruch 14.

16. Energiespeichermodul mit einer Steuerung nach Anspruch 13.

17. Energiespeichersystem mit einer Vielzahl von Energiespeichermodulen mit zumindest einer Steuerung nach Anspruch 13.

18. Fahrzeug, insbesondere ein Schienenfahrzeug oder Luftfahrzeug, mit einem Energiespeichermodul nach Anspruch 16 oder einem Energiespeichersystem nach Anspruch 17.

## Claims

1. Method for controlling the service life of an energy storage module (1), wherein a state of health (SoH) of the energy storage module (1) is known at different times (t), wherein a first state of health (SoH₁), in which the energy storage module (1) finds itself at a first time (t₁), is known, and a second state of health (SoH₂), in which the energy storage module (1) finds itself at a second time (t₂), is known, wherein an ageing rate (v_{SoH}) is determined from the first and second states of health (SoH₁, SoH₂) and from the first and second times (t₁, t₂), wherein a time (t_{END_calc}) of a determined end of service life is calculated from the ageing rate (v_{SoH}) and one of the states of health (SoH), wherein depending on the time (t_{END_calc}) of the determined end of service life, a measure for changing the service life of the energy storage module (1) is applied, wherein the energy storage module (1) comprises double-layer capacitors,
**characterised in that** the cooling capacity of the energy storage module (1) is increased if a temperature (T_{ES}) measured in the energy storage module (1) is greater than an averaged or smoothed value of the temperature (**T̅_̅{̅E̅S̅}̅**) measured in the energy storage module and/or if a measured ambient temperature (T_{amb}) is greater than an averaged or smoothed value of the measured ambient temperature (**T̅_̅{̅a̅m̅b̅}̅**).

2. Method according to claim 1, wherein depending on the size of the time interval between a time (t_{END_plan}) of a scheduled end of service life and the time (t_{END_calc}) of the determined end of service life, a measure for changing the service life of the energy storage module (1) is applied.

3. Method according to one of claims 1 or 2, wherein for the case in which the time (t_{END_calc}) of the determined end of service life lies before the time (t_{END_plan}) of the scheduled end of service life, a measure for changing the service life is applied, wherein the measure for changing the service life is a measure for extending the service life.

4. Method according to one of claims 1 to 3, wherein depending on at least one operating parameter of the energy storage module (1) and/or at least one ambient condition, with the aid of data stored in a memory, open-loop or closed-loop control of the operation of the energy storage module (1) is performed such that in order to change the service life of the energy storage module
- a cooling capacity of the energy storage module (1) is changed and/or
- an operating strategy of the energy storage module (1) is altered and/or
- an operating variable of the energy storage module is limited.

5. Method according to claim 1, wherein the cooling capacity is increased according to the difference between the temperature (T_{ES}) measured in the energy storage module (1) and the measured ambient temperature (T_{amb}).

6. Method according to one of claims 1 to 5, wherein the operating strategy of the energy storage module (1) is altered in the manner that the maximum state of charge (SoCₘₐₓ) is lowered and/or the minimum depth of discharge (DoDₘᵢₙ) is increased.

7. Method according to one of claims 1 to 6, wherein the operating strategy of the energy storage module (1) is altered in the manner that the number of cycles is reduced.

8. Method according to one of claims 1 to 7, wherein the current (I) flowing through the energy storage module (1) is limited.

9. Method according to claim 8, wherein the discharge current (I_{dis}) of the energy storage module (1) is limited.

10. Method for controlling the service life of a multiplicity of energy storage modules (1), wherein closed-loop control of at least a first energy storage module (11) of the multiplicity of energy storage modules (1) having a first time (t_{END_calc, 1}) of the determined end of service life is performed by a method according to one of claims 1 to 9 such that the first time (t_{END_calc, 1}) of the determined end of service life approximates a definable time.

11. Method according to claim 10, wherein closed-loop or open-loop control of the first energy storage module (11) having the first time (t_{END_calc, 1}) of the determined end of service life, which lies earlier in time than a second time (t_{END_calc, 2}) of the determined end of service life of a second energy storage module (12) of the multiplicity of energy storage modules (1), is performed such that the service life of the first energy storage module (11) is extended.

12. Method according to one of claims 10 or 11, wherein closed-loop control of each of the individual energy storage modules (1) is performed such that the respective times (t_{END_calc,i}) of the determined end of service life of the individual energy storage modules (1) approximate one another.

13. Control system (2) for an energy storage module (1) having means for performing a method according to one of claims 1 to 12, wherein the energy storage module (1) comprises double-layer capacitors.

14. Program for performing a method according to one of claims 1 to 12 on being executed in a control system according to claim 13.

15. Computer program product comprising a program according to claim 14.

16. Energy storage module comprising a control system according to claim 13.

17. Energy storage system comprising a multiplicity of energy storage modules comprising at least one control system according to claim 13.

18. Vehicle, in particular a rail vehicle or aircraft, comprising an energy storage module according to claim 16 or an energy storage system according to claim 17.

## Revendications

1. Procédé de réglage de la durée de vie d'un module (1) d'accumulation d'énergie, dans lequel, à des instants (t) différents, un état (SoH) de vieillissement du module (1) d'accumulation d'énergie est connu, dans lequel on connaît un premier état (SoH₁) de vieillissement, dans lequel le module (1) d'accumulation d'énergie se trouve à un premier instant (t₁) et on connaît un deuxième état (SoH₂) de vieillissement, dans lequel le module (1) d'accumulation d'énergie se trouve à un deuxième instant (t₂), dans lequel on détermine, à partir du premier et du deuxième états (SoH₁, SoH₂) de vieillissement et du premier et du deuxième instants (t₁, t₂), une vitesse (v_{SoH}) de vieillissement, dans lequel on calcule, à partir de la vitesse (v_{SoH}) de vieillissement et de l'un des états (SoH) de vieillissement, un instant (t_{END_calc}) de fin de durée de vie déterminé, dans lequel, en fonction de l'instant (t_{END_calc}) de la fin de la durée de vie déterminé, on applique une mesure de modification de la durée de vie du module (1) d'accumulation d'énergie, le module (1) d'accumulation d'énergie comprenant des condensateurs à couche double,
**caractérisé en ce que** l'on augmente la puissance de refroidissement du module (1) d'accumulation d'énergie, si une température (T_{ES}) mesurée dans le module (1) d'accumulation d'énergie est plus haute qu'une valeur en moyenne ou lissée de la température (***T̅_̅{̅E̅S̅}̅***) mesurée dans le module d'accumulation d'énergie et/ou si une température (T_{amb}) ambiante mesurée est plus haute qu'une valeur en moyenne ou lissée de la température (***T̅_̅{̅a̅m̅b̅}̅***) ambiante mesurée.

2. Procédé suivant la revendication 1, dans lequel, en fonction de la grandeur de l'intervalle de temps entre un instant (t_{END_plan}) d'une fin de durée de vie planifiée et l'instant (t_{END_calc}) de la fin de durée de vie déterminée, on applique une mesure de modification de la durée de vie du module (1) d'accumulation d'énergie.

3. Procédé suivant l'une des revendications 1 ou 2, dans lequel, dans le cas où l'instant (t_{END_calc}) de la fin de durée de vie déterminée est antérieur à l'instant (t_{END_plan}) de la fin de durée de vie planifiée, on applique une mesure de modification de la durée de vie, la mesure de modification de la durée de vie étant une mesure de prolongement de la durée de vie.

4. Procédé suivant l'une des revendications 1 à 3, dans lequel, en fonction d'au moins un paramètre de fonctionnement du module (1) d'accumulation d'énergie et/ou au moins d'une condition ambiante, en s'aidant de données mémorisées dans une mémoire, on commande ou on règle le fonctionnement du module (1) d'accumulation d'énergie, de manière à, pour modifier la durée de vie du module d'accumulation d'énergie,
- modifier la puissance de refroidissement du module (1) d'accumulation d'énergie et/ou
- modifier une stratégie de fonctionnement du module (1) d'accumulation d'énergie et/ou
- limiter une grandeur de fonctionnement du module d'accumulation d'énergie.

5. Procédé suivant la revendication 1, dans lequel on augmente la puissance de refroidissement en fonction de la différence entre la température (T_{ES}) mesurée dans le module d'accumulation d'énergie et la température (T_{amb}) ambiante mesurée.

6. Procédé suivant l'une des revendications 1 à 5, dans lequel on modifie la stratégie de fonctionnement du module (1) d'accumulation d'énergie, en ce sens que l'on abaisse l'état (SoCₘₐₓ) de charge maximum et/ou on élève la profondeur (DoDₘᵢₙ) de décharge minimum.

7. Procédé suivant l'une des revendications 1 à 6, dans lequel on modifie la stratégie de fonctionnement du module (1) d'accumulation d'énergie, en ce sens que l'on réduit le nombre des cycles.

8. Procédé suivant l'une des revendications 1 à 7, dans lequel on limite le courant (I) passant dans le module (1) d'accumulation d'énergie.

9. Procédé suivant la revendication 8, dans lequel on limite le courant (I_{dis}) de décharge du module (1) d'accumulation d'énergie.

10. Procédé de réglage de la durée de vie d'une pluralité de modules (1) d'accumulation d'énergie, dans lequel on règle au moins un premier module (11) d'accumulation d'énergie de la pluralité de modules (1) d'accumulation d'énergie à un premier instant (t_{END_calc, 1}) de la fin de durée de vie déterminée, au moyen d'un procédé suivant l'une des revendications 1 à 9, de manière à ce que le premier instant (t_{END_calc, 1}) de la fin de durée de vie déterminée tende vers un instant pouvant être donné à l'avance.

11. Procédé suivant la revendication 10, dans lequel on règle ou on commande le module (11) d'accumulation d'énergie au premier instant (t_{END_calc, 1}) de la fin de durée de vie déterminée, qui est antérieur à un deuxième instant (t_{END_calc, 2}) de la fin de durée de vie déterminée d'un deuxième module (12) d'accumulation d'énergie de la pluralité de modules (1) d'accumulation d'énergie, de manière à prolonger la durée de vie du premier module (11) d'accumulation d'énergie.

12. Procédé suivant l'une des revendications 10 ou 11, dans lequel on règle les divers modules (1) d'accumulation d'énergie, chacun de manière à ce que les instants (t_{END_calc, i}) respectifs de la fin de durée de vie déterminée des divers modules (1) d'accumulation d'énergie se rapprochent les uns des autres.

13. Commande (2) d'un module (1) d'accumulation d'énergie ayant des moyens pour effectuer un procédé suivant l'une des revendications 1 à 12, le module (1) d'accumulation d'énergie comprenant des condensateurs à couche double.

14. Programme pour effectuer un procédé suivant l'une des revendications 1 à 12 lors du déroulement dans une commande suivant la revendication 13.

15. Produit de programme d'ordinateur ayant un programme suivant la revendication 14.

16. Module d'accumulation d'énergie ayant une commande suivant la revendication 13.

17. Système d'accumulation d'énergie ayant une pluralité de modules d'accumulation d'énergie ayant au moins une commande suivant la revendication 13.

18. Véhicule, notamment véhicule ferroviaire ou aéronef, ayant un module d'accumulation d'énergie suivant la revendication 16 ou un système d'accumulation d'énergie suivant la revendication 17.
